# EUROPÄISCHE PATENTANMELDUNG

(11) **EP 2 641 664 A2**
(43) Veröffentlichungstag der Anmeldung: **25.09.2013**
(21) Anmeldenummer: 13157680.3
(22) Anmeldetag: 04.03.2013
(51) Int. Cl.: B05C 1/00, B05C 11/10

(54) **Handgerät zum Benetzen von U-förmig verklebtem Klebeband**

(30) Priorität: 21.03.2012 DE 102012204460
(71) Anmelder: Tesa SE, 20253 Hamburg (DE)
(72) Erfinder: Schwertfeger, Michael, 22147 Hamburg (DE)

(57) **Zusammenfassung**

Offenbart wird ein Handgerät (1) zum Benetzen von U-förmig verklebtem Klebeband (2). Dieses weist einen Vorratsbehälter (3) für Benetzungsflüssigkeit (4), einen länglichen, im Querschnitt innenseitig U-förmigen Grundkörper (5) sowie mindestens zwei saugfähige Benetzungsauflagen (10, 11) auf, die innerhalb des Grundkörpers einander gegenüberliegend angeordnet sind. Der Grundkörper ist zur Aufnahme eines flachen, an einer Kante mit Klebeband U-förmig umgebenen Objektes (6) geeignet, wobei der Grundkörper zwei einander gegenüberliegende Seitenbereiche (7, 8) und einen dazwischen befindlichen Bodenbereich (9) aufweist. Zwischen dem Vorratsbehälter und den Benetzungsauflagen ist ein Flüssigkeitsleitsystem für die Benetzungsflüssigkeit vorgesehen, das wenigstens teilweise innerhalb des Grundkörpers verläuft. Verwendung findet das offenbarte Handgerät u.a. zum Benetzen von Solarlaminat.

## Beschreibung

### Gebiet der Erfindung

Die Erfindung betrifft ein Handgerät zum Benetzen von U-förmig verklebtem Klebeband. Das Handgerät kann dabei insbesondere bei der Herstellung von Solarmodulen bzw. Solarlaminat eingesetzt werden.

### Stand der Technik

Bei der Herstellung von Solarmodulen werden diese an den Kanten U-förmig von einem beidseitig klebenden Klebeband umgriffen. In einem weiteren Verfahrensschritt ist es notwendig, die Kante bzw. Kanten des Moduls in ein entsprechendes Profil einzuschieben. Bei diesem Produktionsschritt ist es erforderlich, dass die freiliegende außen befindliche Klebemasse vorübergehend inaktiviert wird. Diese Inaktivierung kann insbesondere dadurch erfolgen, dass ein spezieller Flüssigkeitsfilm wie beispielsweise Seifenlauge auf die Klebemasse aufgebracht wird. Dieses Aufbringen erfolgt aktuell mithilfe von Pinseln und Schwämmen. Die Klebemasse klebt nach der Benetzung mit dem Flüssigkeitsfilm dann für einen gewissen Zeitraum nicht. Dampft der Flüssigkeitsfilm später ab, so stellt sich die ursprüngliche Klebkraft der Klebemasse nahezu vollständig wieder ein.

Das händische Aufbringen eines inaktivierenden Flüssigkeitsfilmes mithilfe von Schwämmen und/oder Pinseln ist dabei verhältnismäßig umständlich bzw. zeitaufwändig. Häufig fehlt es dabei an örtlicher Präzision und Dosierungsgenauigkeit.

### Beschreibung der Erfindung

Es ist die Aufgabe der vorliegenden Erfindung, die Nachteile des Standes der Technik zu überwinden und eine vereinfachte bzw. verbesserte Möglichkeit bereitzustellen, U-förmig verklebtes Klebeband mit Flüssigkeit zu benetzen.

Die Aufgabe wird gelöst durch den Gegenstand der unabhängigen Patentansprüche 1 und 22. Vorteilhafte Ausführungsformen der Erfindung werden durch die abhängigen Patentansprüche definiert.

Die Erfindung bezieht sich auf ein Handgerät zum Benetzen von U-förmig verklebtem Klebeband. Dabei kann das Gerät insbesondere zum Benetzen von Solarlaminat verwendet werden, das von U-förmig verklebtem Klebeband eingefasst ist. Das offenbarte Handgerät ist das erste seiner Art. Es wird erstmalig ein Arbeitsgerät zur Verfügung gestellt, mit dessen Hilfe ein Benetzen von U-förmig verklebtem Klebeband in einem einzigen Prozessschritt erfolgen kann. Die Dosierung und Positionierung der zur Benetzung verwendeten Flüssigkeit erfolgt bei der Verwendung des Handgerätes automatisch.

Dabei weist das erfindungsgemäße Handgerät einen Vorratsbehälter für Benetzungsflüssigkeit auf. Dieser Vorratsbehälter kann dabei dauerhaft mit dem Handgerät verbunden sein, es ist aber auch möglich, den Vorratsbehälter so mit dem Handgerät zu verbinden, dass der Vorratsbehälter ausgetauscht werden kann. Als Benetzungsflüssigkeit kommen unterschiedliche Flüssigkeiten infrage. Im Zusammenhang mit der vorübergehenden Inaktivierung von Klebemassen von Klebeband handelt es sich insbesondere um Seifenlaugen.

Des Weiteren weist das Handgerät einen länglichen, im Querschnitt innenseitig U-förmigen Grundkörper zur Aufnahme eines flachen, an einer Kante mit Klebeband U-förmig umgebenen Objektes auf, wobei der Grundkörper zwei einander gegenüberliegende Seitenbereiche und einen dazwischen befindlichen Bodenbereich aufweist. Vereinfacht ausgedrückt handelt es sich bei dem Grundkörper also um ein U-förmiges Profil. Dieses ist typischerweise zwischen 8 cm und 12 cm lang, bevorzugt circa 10 cm lang. Die Höhe bzw. Dicke des Grundkörpers beträgt bevorzugt maximal 5 cm, da bei größeren Dicken bzw. Höhen das Umgreifen des Grundkörpers mit einer Hand Probleme bereiten würde. Der Grundkörper bzw. das Profil ist an der oberen Seite des U sowie an den Seitenschnitten des Profils offen ausgebildet, so dass ein flaches Objekt in den Grundkörper bzw. das Profil hineingeschoben und dann in diesem Profil entlang geschoben werden kann. Bei dem flachen, an einer Kante mit Klebeband U-förmig umgebenen Objekt kann es sich beispielsweise um ein Solarmodul bzw. um Solarlaminat handeln, dessen Kanten U-förmig von einem beidseitig klebenden Klebeband umgriffen sind. Das Solarmodul bzw. das Solarlaminat ist mit den vom Klebeband U-förmig umgriffenen Kanten in den Grundkörper einschiebbar bzw. an diesem entlang schiebbar und hindurch schiebbar. Die beiden einander gegenüberliegenden Seitenbereiche bilden dabei sozusagen die Führungselemente bzw. Führungsschienen und der zwischen den Seitenbereichen befindliche Bodenbereich den tiefen Anlagebereich für das hineingeschobene Objekt. Der Grundkörper selbst kann dabei ein- oder mehrteilig ausgebildet sein. Er kann als Materialien beispielsweise Metall wie z.B. eloxiertes Aluminium oder Edelstahl oder aber Kunststoff aufweisen.

Das erfindungsgemäße Handgerät verfügt des Weiteren über mindestens zwei saugfähige Benetzungsauflagen, die innerhalb des Grundkörpers einander gegenüberliegend angeordnet sind. Die Benetzungsauflagen befinden sich also innerhalb des Profiles zweckmäßigerweise den beiden einander gegenüberliegenden Seitenbereichen zugeordnet. Die Benetzungsauflagen können dabei insbesondere Filz, Vlies und/oder Schaumstoff aufweisen. Durch ein Entlangführen der mit Flüssigkeit getränkten Benetzungsauflagen auf bzw. an dem Objekt erfolgt der Benetzungsprozess bzw. insbesondere eine mögliche Inaktivierung von Klebemassen. Dabei ist der Grundkörper mit den in ihm angeordneten Benetzungsauflagen bevorzugt so dimensioniert, dass unterschiedlich dicke Solarmodule mit dem darauf angebrachten Klebeband so in den Grundkörper hineingeschoben werden können, dass jeweils ein hinreichend enger Kontakt zwischen den Benetzungsauflagen einerseits und der zu benetzenden Solarmodulkante andererseits vorhanden ist. Die unterschiedlich dicken Solarmodule können dabei bei hinreichender Dicke der Benetzungsauflagen gleichermaßen gut mit dem erfindungsgemäßen Handgerät mit Flüssigkeit benetzt werden. Mit Klebeband U-förmig umfasste Solarmodule weisen typischerweise eine Dicke von 7 ± 2 mm auf. Entsprechend darauf abgestimmt kann die Beabstandung zwischen den einander gegenüberliegenden Benetzungsauflagen bzw. die Dimension der U-förmigen Öffnung des Grundkörpers gewählt werden.

Erfindungsgemäß ist zwischen dem Vorratsbehälter und den Benetzungsauflagen ein Flüssigkeitsleitsystem für die Benetzungsflüssigkeit vorgesehen, das wenigstens teilweise innerhalb des Grundkörpers verläuft. Dieses Flüssigkeitsleitsystem kann dabei aus einem oder mehreren Rohren oder Kanälen bestehen. Diese können innerhalb oder außerhalb des Grundkörpers verlaufen. Das Flüssigkeitsleitsystem verbindet also den Vorratsbehälter mit den Benetzungsauflagen und verläuft dabei wenigstens teilweise innerhalb des Grundkörpers.

Gemäß einer bevorzugten Ausführungsform der Erfindung weist das Flüssigkeitsleitsystem eine Verzweigung derart auf, dass ein Zweig hin zu der ersten Benetzungsauflage und ein zweiter Zweig hin zu der zweiten Benetzungsauflage verläuft. Den beiden Benetzungsauflagen wird also zunächst über einen Abschnitt des Flüssigkeitsleitsystems gemeinsam Flüssigkeit zugeführt bzw. Flüssigkeit ist zuführbar, dann jedoch erfolgt eine Trennung bzw. Aufteilung im Verzweigungspunkt, und beispielsweise ein erstes Kanal-oder Rohrsystem wird hin zur ersten Benetzungsauflage und ein zweites Kanal- oder Rohrsystem hin zu der zweiten Benetzungsauflage geführt. Der Vorteil von Verzweigungen liegt dabei in einem insgesamt kurzen Flüssigkeitsleitsystem und damit in einem sparsamen Materialverbrauch. Die Zweige des Flüssigkeitsleitsystems können dabei in Kanal- oder Rohrform mit rundem Querschnitt oder aber mit eckigem Querschnitt oder aber gänzlich anders ausgestaltet vorliegen. Typischerweise können Röhrchen oder Kanäle mit einem Innendurchmesser im Millimeterbereich verwendet werden, in denen ein Flüssigkeitstransport gravitativ bzw. durch Druck oder auch mithilfe einer Kapillarwirkung erfolgen kann. Bevorzugt beträgt der Innendurchmesser zwischen 0,8 mm und 2 mm, welcher im Falle von gefrästen Kanälen fertigungstechnisch verhältnismäßig einfach zu realisieren ist.

Gemäß einer bevorzugten Ausführungsform der Erfindung ist die Verzweigung im Bereich des Grundkörpers vorgesehen. Das bedeutet, dass die Verzweigung innerhalb des Grundkörpers oder an den Grundkörper angrenzend, beispielsweise an einer seiner Oberflächen vorgesehen sein kann. In einer besonders bevorzugten Ausführungsform ist eine solche Verzweigung in bzw. an dem Bodenbereich des Grundkörpers vorgesehen.

Gemäß einer bevorzugten Ausführungsform der Erfindung sind die beiden oben beschriebenen Zweige konstruktiv identisch ausgebildet. Das bedeutet, dass die beiden Zweige im Wesentlichen identisch bzw. einander entsprechend ausgebildet sind. Dies trifft auch auf spiegelbildlich ausgebildete Zweige zu, die ansonsten einen im Wesentlichen identischen Verlauf bzw. im Wesentlichen identischen Abmessungen in Form, Länge und Innendurchmesser aufweisen. Sind die beiden Zweige konstruktiv identisch ausgestaltet, so lassen sich diese auf besonders einfache Weise herstellen. Alternativ ist es aber auch möglich, dass die beiden Zweige konstruktiv unterschiedlich ausgestaltet sind. Sie können also beispielsweise insgesamt verschieden lang sein und/oder einen anderen Innendurchmesser oder einen anderen Außendurchmesser aufweisen. Die beiden Zweige können jedoch auch aus unterschiedlichen Materialien und ansonsten einander entsprechend ausgestaltet sein.

Alternativ ist es auch denkbar, ein Flüssigkeitsleitsystem ohne jede Verzweigung vorzusehen. Um dennoch beide Benetzungsauflagen mit Flüssigkeit versorgen zu können, können entweder gänzlich unterschiedliche Flüssigkeitsleitungen hin vom gemeinsamen Vorratsbehälter hin zu jeder der Benetzungsauflage vorgesehen sein. Alternativ ist es aber auch möglich, ein Flüssigkeitsleitsystem vorzusehen, das zunächst eine Benetzung der ersten Benetzungsauflage und dann in Weiterführung, sozusagen in Reihe liegend, eine Benetzung der zweiten Benetzungsauflage vornimmt. Auch andere Ausgestaltungen des Flüssigkeitsleitsystems sind grundsätzlich denkbar.

Gemäß einer bevorzugten Ausführungsform der Erfindung verläuft das Flüssigkeitsleitsystem durch die beiden Seitenbereiche des Grundkörpers hindurch hin zu den beiden Benetzungsauflagen. Bevorzugt ist es dabei so, dass ein Kanal oder Rohr innerhalb der Seitenbereiche des Grundkörpers ausgebildet ist, durch den bzw. durch das Flüssigkeit hindurch zu den Benetzungsauflagen gelangen kann. Dabei ist die Orientierung des Flüssigkeitsleitsystems in den beiden Seitenbereichen bevorzugt orthogonal zu den beiden Benetzungsauflagen (bzw. die Richtung des Rohrsystems entspricht der Normalen, die auf den Benetzungsauflagen errichtet werden kann). Eine solche konstruktive Ausgestaltung ist verhältnismäßig einfach zu realisieren und erlaubt eine schnelle und direkte Versorgung der Benetzungsauflagen mit Flüssigkeit.

Gemäß einer weiteren bevorzugten Ausführungsform der Erfindung weist das Flüssigkeitsleitsystem ein Ventilsystem zur Unterbrechung bzw. Freigabe der Flüssigkeitszufuhr auf. Ein solches Ventilsystem kann ein- oder mehrteilig ausgebildet sein. Es kann über ein oder mehrere Ventile verfügen. Das Ventilsystem selbst kann dabei an unterschiedlichen Positionen des Flüssigkeitsleitsystems vorgesehen sein. Es ist möglich, ein solches Ventilsystem unmittelbar angrenzend an den Vorratsbehälter für die Benetzungsflüssigkeit vorzusehen. Alternativ und bevorzugt ist es aber so, dass das Ventilsystem im Bereich einer Verzweigung des Flüssigkeitsleitsystems angeordnet ist. Dies bedeutet, dass sich bei einer Öffnung des Ventils ein Flüssigkeitsstrom durch die Verzweigung hindurch in die mindestens zwei sich an diesen Verzweigungspunkt anschließenden Zweige bewegen kann. Dabei kann sich wiederum bevorzugt das Ventilsystem bzw. die Verzweigung im bzw. am Grundkörper, insbesondere im bzw. am Bodenbereich des Grundkörpers befinden. Ein Ventilsystem ermöglicht eine optimale Nutzung der zur Benetzung verwendeten Flüssigkeit. Ist das verwendete Handgerät nicht mehr im Einsatz, so kann ein Mechanismus zum Schließen des Ventils derart vorgesehen sein, dass nicht unnötig Flüssigkeit aus dem Vorratsbehälter freigesetzt wird.

Gemäß einer bevorzugten Ausführungsform der Erfindung ist das Ventilsystem mithilfe eines Bedienelementes betätigbar. Dabei kann es sich um einen einfachen Knopf oder einen einfachen Schalter handeln, der beispielsweise mechanisch oder elektronisch arbeitet.

Alternativ weist das Ventilsystem eine federnd gelagerte Kontaktplatte auf, die innerhalb der im Querschnitt U-förmigen Öffnung des Grundkörpers angeordnet ist und die durch Kontakt bzw. Druck so bewegt werden kann, dass sich das Ventilsystem öffnet bzw. schließt. Durch die Anordnung der Kontaktplatte innerhalb der im Querschnitt U-förmigen Öffnung des Grundkörpers kann ein in den Grundkörper hineingeschobenes Objekt in Kontakt mit der Kontaktplatte gelangen bzw. diese entgegen dem Federmechanismus in Richtung auf den Bodenbereich des Grundkörpers zubewegen. Eine derartige Verschiebung der Kontaktplatte öffnet über eine entsprechende Mechanik das Ventil des Ventilsystems. Ein Flüssigkeitsaustritt bzw. eine Flüssigkeitszufuhr hin zu den Benetzungsauflagen wird ermöglicht. Durch die Verwendung der beschriebenen Kontaktplatte kann erreicht werden, dass eine Flüssigkeitsbereitstellung nur dann erfolgt, wenn sich auch tatsächlich ein zu benetzendes Objekt innerhalb des Grundkörpers bzw. Handgerätes befindet. Ein unnötiger Flüssigkeitsaustritt wird vermieden, Verschmutzungen werden verhindert, Kosten werden reduziert. Bevorzugt ist die Kontaktplatte so ausgebildet, dass sie den gesamten hinteren innen liegenden Bereich des Grundkörpers, sprich dessen Bodenbereich überdeckt, so dass ein in den Grundkörper hineingeschobenes Objekt mit seiner Seitenfläche in Gänze an der Kontaktplatte zur Anlage gelangen kann. Theoretisch ist es auch denkbar, die Kontaktplatte mehrteilig oder in anderer Dimensionierung vorzusehen. Die Federung kann beispielsweise mithilfe einer Spiralfeder oder Blattfeder erfolgen. Bevorzugt ist es so, dass die Kontaktplatte so angeordnet ist, dass sie orthogonal zu den beiden Benetzungsauflagen ist.

Gemäß einer weiteren bevorzugten Ausführungsform der Erfindung weist das Ventilsystem mehrere Ventile und/oder das Flüssigkeitsleitsystem mehrere Verzweigungen auf. Dabei ist es insbesondere möglich, dass mehrere baugleiche Baugruppen von Ventilen bzw. Flüssigkeitsleitsystemabschnitten entlang der Längsachse des U-förmigen Grundkörpers hintereinander liegend angeordnet sind. Auch diese Ausführungsvarianten können mit der oben beschriebenen Kontaktplatte oder aber mit oben beschriebenen Kontaktplatten ausgestattet sein. Vorteilhaft ist aber die Kopplung an eine einzige Kontaktplatte, damit das Entlanggleiten des in den Grundkörper eingeschobenen Objektes an dieser Kontaktplatte stufenlos und stetig erfolgen kann.

Gemäß einer weiteren bevorzugten Ausführungsform der Erfindung ist das Flüssigkeitsleitsystem teilweise an bzw. auf der Oberfläche des Grundkörpers angeordnet. Bestandteile des Flüssigkeitsleitsystems können sich also an bzw. auf der Oberfläche der Seitenbereiche und/oder des dazwischen befindlichen Bodenbereiches befinden. Es ist möglich, z.B. einzelne Rohrstücke bzw. Abschnitte auf die Oberfläche des Grundkörpers beispielsweise aufzukleben oder daran anzuformen. Alternativ ist es möglich, die Oberfläche des Grundkörpers einzukerben bzw. Kanäle dadurch im Wesentlichen innerhalb des Grundkörpers vorzusehen.

Die Benetzungsauflagen können aus einem oder mehreren Materialien aufgebaut sein, sie können insbesondere Filz, Vlies und/oder Schaumstoff aufweisen. Gemäß einer bevorzugten Ausführungsform sind die Benetzungsauflagen umfänglich rechteckig und innerhalb des Grundkörpers jeweils fest mit einem der Seitenbereiche verbunden. Vorteilhaft ist es so, dass dabei eine Benetzungsauflage im Wesentlichen einen Seitenbereich vollständig bedeckt bzw. abdeckt. Dabei ist es möglich, dass eine einzelne Benetzungsauflage an ihrer Rückseite bzw. im Seitenbereich des Grundkörpers von mehreren Flüssigkeitsaustrittsöffnungen aus mit Flüssigkeit versorgt wird.

Gemäß einer alternativen Ausführungsform der Erfindung sind die Benetzungsauflagen, die innerhalb des Grundkörpers vorgesehen sind, umfänglich rund und rotationsfähig jeweils vor einem der Seitenbereiche angeordnet. Es ist beispielsweise möglich, die umfänglich runden Benetzungsauflagen durch die Implementierung eines Antriebes in Rotation zu versetzen, um die Benetzungsflüssigkeit besonders gut und gleichmäßig auf der Oberfläche des zu benetzenden Objektes zu verteilen. Gemäß einer vorteilhaften Ausführungsform ist es dabei so, dass je Seitenbereich des Grundkörpers mehrere umfänglich runde und rotationsfähige Benetzungsauflagen, z.B. in Reihe liegend, vorgesehen sind. Das Handgerät verfügt demgemäß über mehr als zwei Benetzungsauflagen insgesamt.

Gemäß einer weiteren bevorzugten Ausführungsform der Erfindung ist der Vorratsbehälter für Benetzungsflüssigkeit im Wesentlichen flach ausgebildet. Es handelt sich also nicht um eine Flasche, sondern eher um einen flachen Kanister. Dieser weist bevorzugt eine maximale Höhe bzw. Füllhöhe von etwa 20 mm bis etwa 120 mm auf. Die flache Ausbildung des Vorratsbehälters sorgt dafür, den hydrostatischen Druck beim Ausströmen der Flüssigkeit nicht zu hoch werden zu lassen, so dass bei geöffnetem Ventil und vollem Vorratsbehälter keine Überdosierung bei der Benetzung erfolgt, dennoch aber bei fast leerem Vorratsbehälter eine noch ausreichende Dosierung sichergestellt ist. Gemäß einer bevorzugten Ausführungsform der Erfindung ist der Vorratsbehälter im Wesentlichen quaderförmig ausgebildet. Bevorzugt ist er an einem der Seitenbereiche des Handgerätes angeordnet. Bevorzugt sind die Dimensionen von Vorratsbehälter einerseits und Seitenbereich andererseits so aufeinander abgestimmt, dass sich der Vorratsbehälter vollständig über dem Seitenbereich befindet bzw. am Rande mit diesem abschließt.

Gemäß einer bevorzugten Ausführungsform der Erfindung weist der Vorratsbehälter eine Einfüllöffnung für Flüssigkeit und/oder eine oder mehrere Auslassöffnungen zu dem Flüssigkeitsleitsystem auf. Dabei können diese Auslassöffnungen beispielsweise in Längsachsrichtung des Handgerätes hintereinander liegend, bevorzugt gleichmäßig voneinander beabstandet, vorgesehen sein. Es ist aber auch möglich, dass die Auslassöffnungen in zwei zueinander parallelen Reihen vorgesehen sind. Dies ist insbesondere dann der Fall, wenn das Flüssigkeitsleitsystem ohne Verzweigungen vorgesehen ist.

Gemäß einer bevorzugten Ausführungsform der Erfindung weist das erfindungsgemäße Handgerät einen Griff auf, der sich außenseitig entlang des Bodenbereiches des Grundkörpers erstreckt. Auf diese Weise lässt sich ein besonders kompaktes und in der Handhabung besonders praktisches Handgerät realisieren. Bevorzugt verläuft der Griff über die gesamte Außenseite des Grundkörpers.

Gemäß einem weiteren Aspekt der Erfindung bezieht sich diese auf die Verwendung eines oben beschriebenen Handgerätes zum Benetzen von Solarlaminat. Genauer gesagt wird das um die Kanten herum U-förmig am Solarlaminat befestigte Klebeband, von dem die Abdeckung bzw. der Liner bereits entfernt wurde, mithilfe des Handgerätes mit Flüssigkeit benetzt, um die Klebmasse des doppelseitigen Klebebands vorübergehend zu inaktivieren, so dass das Solarlaminat problemlos in ein Profil hineinschiebbar ist.

Die beschriebenen Ausführungsformen der Erfindung lassen sich ganz oder teilweise miteinander kombinieren.

Die Erfindung wird zudem noch besser verstanden werden unter Bezugnahme auf die beigefügten Figuren. Dabei zeigen:
- Fig. 1:: zeigt ein erstes Ausführungsbeispiel für ein erfindungsgemäßes Handgerät in perspektivisch-schematischer Darstellung;
- Fig. 2:: zeigt das in Fig. 1 dargestellte Ausführungsbeispiel in einer Schnittansicht in schematischer Darstellung; und
- Fig. 3:: zeigt ein zweites Ausführungsbeispiel der Erfindung in einer schematischen Schnittansicht.

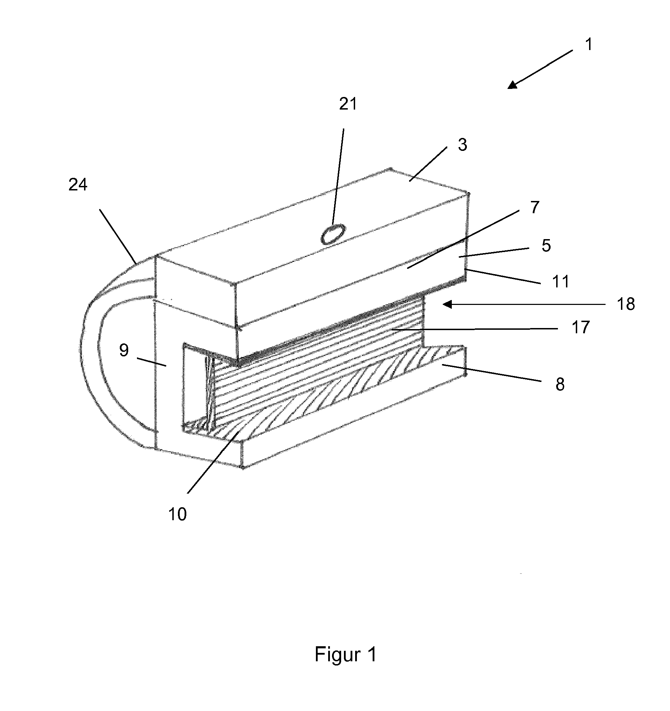

Fig. 1 zeigt ein erstes Ausführungsbeispiel für das erfindungsgemäße Handgerät 1 in perspektivisch-schematischer Darstellung. Das dargestellte Handgerät 1 verfügt über einen länglichen Grundkörper 5. Dieser Grundkörper 5 ist im Wesentlichen in Form eines langgestreckten Profils ausgebildet. Er verfügt somit über eine U-förmige Öffnung 18, wobei diese Öffnung entlang der Längsachse des Handgerätes 1 offen ausgebildet ist. Auch an den Seitenflächen ist die Öffnung 18 durchgehend ausgebildet. Der Grundkörper 5 lässt sich in drei verschiedene Bereiche unterteilen: Er umfasst die beiden Seitenbereiche 7 und 8 sowie einen Bodenbereich 9, der in Fig. 1 in der Zeichnung seitlich dargestellt ist. Die verschiedenen Bereiche des Grundkörpers 5 können dabei aus einem Stück gefertigt sein; es ist aber auch möglich, dass der Grundkörper 5 aus verschiedenen Teilen zusammengesetzt ist. Innerhalb der Öffnung 18 ist an den beiden Seitenbereichen 7 und 8 jeweils eine Benetzungsauflage 11 bzw. 10 vorgesehen. Diese Benetzungsauflagen 11 bzw. 10 sind im gezeigten Beispiel im Wesentlichen rechteckig und bedecken im Wesentlichen den gesamten Innenbereich der Seitenbereiche 7 bzw. 8. Im dargestellten Beispiel handelt es sich beispielsweise um Benetzungsauflagen 10 bzw. 11, die ein Filz, ein Vlies und/oder Schaumstoff aufweisen.

Oberhalb des Grundkörpers 5 ist ein Vorratsbehälter 3 für Benetzungsflüssigkeit vorgesehen. Über eine Einfüllöffnung 21 kann Benetzungsflüssigkeit nachgefüllt bzw. erstmalig eingefüllt werden. Der Vorratsbehälter 3 ist im Wesentlichen flach ausgebildet und erstreckt sich in seinen Abmessungen im Wesentlichen analog den Abmessungen des Seitenbereiches 7 des Grundkörpers 5. An der Rückseite des Handgerätes 1 ist ein Griff 24 vorgesehen. Der Griff 24 erstreckt sich dabei im Wesentlichen entlang der Längsachse des Handgerätes 1 und ist an der geschlossenen Seite des U-Profils des Grundkörpers 5 vorgesehen. Im Inneren der Öffnung 18 des Grundkörpers 5 ist des Weiteren eine Kontaktplatte 17 zu erkennen. Diese Kontaktplatte 17 kann bei Kontakt eines in den Grundkörper 5 hineingeschobenen Gegenstandes wie beispielsweise eines Solarmoduls beispielsweise entgegen einer Federkraft auf den Bodenbereich 9 des Grundkörpers 5 zubewegt werden. Durch diese Bewegung ist es möglich, ein Ventilsystem freizugeben, so dass Benetzungsflüssigkeit vom Vorratsbehälter 3 über ein in Fig. 1 nicht erkennbares Flüssigkeitsleitsystem hin zu den beiden Benetzungsauflagen 10 bzw. 11 gelangen kann, um beim Entlangführen des Handgerätes 1 beispielsweise an einem Solarmodul die mit den Benetzungsauflagen 10 bzw. 11 in Kontakt kommenden Bereiche gleichmäßig mit Flüssigkeit zu benetzen. Auf diese Weise kann beispielsweise die Klebmasse eines Klebebandes, das Kanten eines Solarmoduls bzw. Solarlaminates U-förmig umgibt, vorübergehend inaktiviert werden, so dass ein Montageprozess von Solarmodulen bzw. Solarlaminat wie beispielsweise ein Hineinführen in Rahmen bzw. Profile ohne Behinderung durch die Klebmasse erfolgen kann.

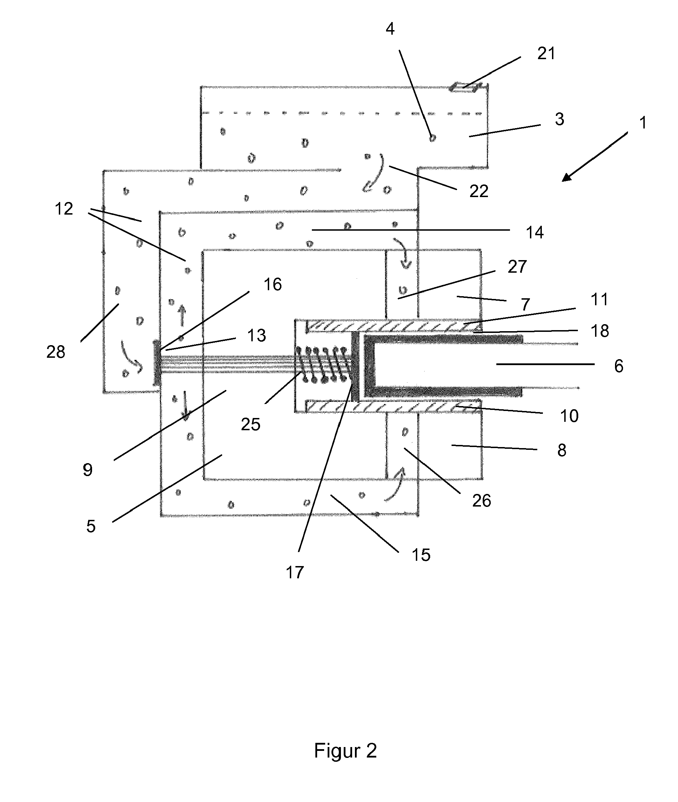

Fig. 2 zeigt im Wesentlichen die in Fig. 1 dargestellte Ausführungsform eines Handgerätes 1 in einer schematischen Schnittansicht. Dabei wurde in dieser Schnittansicht aus Gründen der Übersichtlichkeit der Griff 24 nicht mit dargestellt. Die dargestellte Schnittansicht soll im Wesentlichen die Anordnung und Funktionsweise des Flüssigkeitsleitsystems 12 des Handgeräts 1 illustrieren. Im oberen Bereich von Fig. 2 ist wieder ein Vorratsbehälter 3 für Benetzungsflüssigkeit 4 wie beispielsweise Seifenlauge vorgesehen. Durch eine Austrittsöffnung 22 gelangt Benetzungsflüssigkeit in ein Flüssigkeitsleitsystem 12. Die Pfeile in Fig. 2 sollen die Flussrichtung der Flüssigkeit 4 illustrieren. Dabei gelangt die Flüssigkeit 4 zunächst in einen Leitungsabschnitt 28, der sich außerhalb des Grundkörpers 5 befindet. Der Leitungsabschnitt 28 verläuft zunächst in Fig. 2 waagerecht, bevor er dann senkrecht an der Rückseite des Grundkörpers 5, sprich benachbart des Bodenbereiches 9 äußerlich geführt wird. In Strömungsrichtung am unteren Ende im Leitungsabschnitt 28 befindet sich ein Ventil 16. Dieses Ventil 16 verschließt bzw. öffnet einen weiteren Abschnitt des Flüssigkeitsleitsystems. Im gezeigten Beispiel befindet sich das Ventil 16 an einem Verzweigungspunkt 13. Das Flüssigkeitsleitsystem 12 verzweigt sich in einen oberen ersten Zweig 14 und einen unteren zweiten Zweig 15. Beide Zweige führen jeweils zu einer der Benetzungsauflagen 11 bzw. 10 des Handgeräts 1. Dabei verlaufen Bereiche beider Zweige 14 bzw. 15 zunächst an der äußeren Oberfläche des Grundkörpers 5 und treten dann in den Grundkörper 5 ein bzw. durch diesen hindurch. Kanalabschnitte 26 bzw. 27 verlaufen also innerhalb des Grundkörpers 5. Genauer gesagt sind diese Kanalabschnitte 26 bzw. 27 in den beiden Seitenbereichen 8 bzw. 7 des Grundkörpers 5 angeordnet. Dabei ist ihre Orientierung senkrecht zur äußeren Oberfläche der Seitenbereiche 7 bzw. 8, so dass die Strömungsrichtung in den Kanalabschnitten 26 bzw. 27 auch orthogonal zu den beiden Benetzungsauflagen 10 bzw. 11 ist.

In das in Fig. 2 dargestellte Handgerät 1 kann nun z.B. ein Solarmodul 6 hineingeschoben bzw. darin entlanggeführt werden. Dieses Solarmodul 6 ist an seiner Kante von doppelseitig klebendem Klebeband 2 U-förmig umgriffen. Die außen liegende Seite des Klebebandes 2 ist dabei freigelegt bzw. die Abdeckung bzw. der so genannte Liner wurde entfernt, so dass die außen liegende Oberfläche des Klebebandes 2 grundsätzlich klebt. Bei Hineinführen des Solarmodules 6 kommt es nun zum Kontakt zwischen dem Solarmodul 6 und der Kontaktplatte 17 des Ventilsystems 16. Die Kontaktplatte 17 kann dabei entgegen dem Federdruck der Feder 25 in Fig. 2 nach links, d.h. in Richtung des Bodenbereiches 9 des Grundkörpers 5 bewegt werden. Durch diese Bewegung öffnet sich - vermittelt über eine Stange 30 - das Ventil 16 am Verzweigungspunkt 13, so dass Flüssigkeit 4 über die beiden Zweige 14 bzw. 15 des Flüssigkeitsleitsystems 12 hin zu den beiden Benetzungsauflagen 11 bzw. 10 gelangen kann und dort in Kontakt mit der Außenseite des Klebebandes 2 gerät, um die Klebmasse an dieser Außenseite vorübergehend zu inaktivieren. Wird das Solarmodul 6 entlang der Längsachsenrichtung des Handgeräts 1 bzw. des Grundkörpers 5 bewegt und bleibt das Solarmodul 6 dabei vollständig eingeführt, so bleibt auch das Ventilsystem 16 die ganze Zeit geöffnet. Es erfolgt also eine stetige Zufuhr von Benetzungsflüssigkeit 4. In dem Moment jedoch, in dem das Solarmodul 6 komplett entlanggeführt oder aber seitlich herausgenommen wird, verschiebt sich die Kontaktplatte 17 aufgrund des Druckes der Feder 25 in Fig. 2 zurück nach rechts, so dass sich das Ventil 16 verschließt. Ein unnötiger Flüssigkeitsaustritt 4 wird somit vermieden. Das Entlangführen des Solarmoduls 6 in dem Handgerät 1 erfolgt zweckmäßigerweise durch ein Entlangführen des Handgerätes 1 an dem fixierten Solarmodul 6, wobei das Handgerät 1 mithilfe des in Fig. 2 nicht dargestellten Griffes bewegt wird. Letztlich ist aber lediglich die Relativbewegung zwischen Handgerät 1 und Solarmodul 6 entscheidend.

In Fig. 2 sind die beiden Zweige 14 bzw. 15 des Flüssigkeitsleitsystems 12 im Wesentlichen identisch ausgebildet. Sie sind symmetrisch ausgestaltet und unterscheiden sich nur in ihrem Einbau hinsichtlich oben befindlich und unten befindlich. Die beiden Zweige 14 bzw. 15 verfügen dabei über eine im Wesentlichen identische Länge und Dimensionierung und sind aus demselben Material hergestellt. Bis auf die spiegelbildliche Anordnung sind die beiden Zweige 14 bzw. 15 also vollkommen identisch.

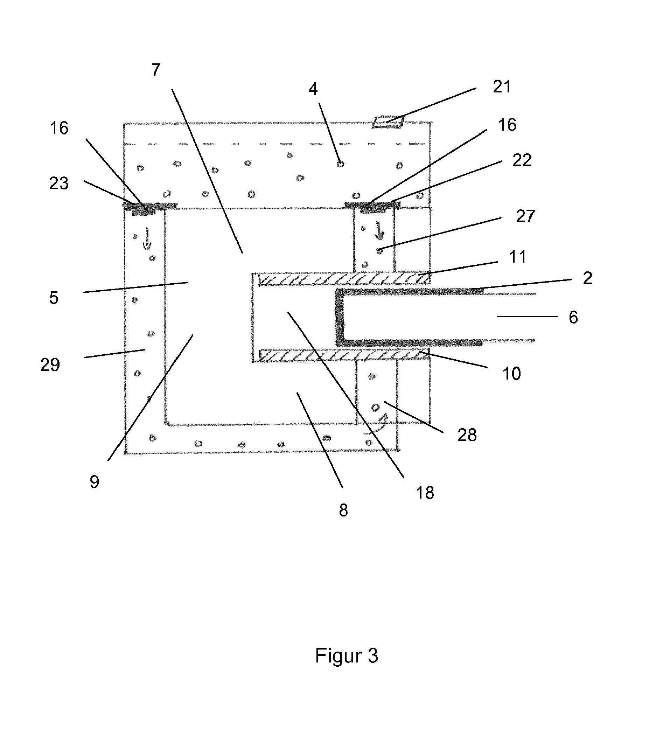

In dieser Hinsicht anders ist das in Fig. 3 gezeigte zweite Ausführungsbeispiel der Erfindung. Hierbei handelt es sich um ein Handgerät 1, das über ein Flüssigkeitsleitsystem 12 ohne Verzweigungspunkte verfügt. In der schematischen Schnittansicht befindet sich oben wiederum ein Vorratsbehälter 3 mit Benetzungsflüssigkeit 4. Der Vorratsbehälter 3 verfügt über zwei Austrittsöffnungen 22 und 23, die jeweils mit einem Ventilsystem 16 ausgestattet sind. Anders als im vorangehenden Ausführungsbeispiel werden die Ventile 16 über ein Bedienelement händisch geöffnet bzw. geschlossen. Dies kann z.B. mechanisch oder elektrisch erfolgen. Dabei erfolgt die Öffnung der Ventile 16 im Wesentlichen zeitgleich, so dass gleichzeitig eine Flüssigkeitszufuhr in die unterschiedlichen Leitungsabschnitte des Flüssigkeitsleitsystems 12 erfolgt. Von der Austrittsöffnung 23 fließt Flüssigkeit 4 durch einen Leitungsabschnitt 29 zunächst senkrecht hinab und später waagerecht an der unteren äußeren Oberfläche des Seitenbereiches 8 des Grundkörpers 5 entlang, danach tritt die Flüssigkeit in einen Kanalabschnitt 28 ein und erreicht schließlich eine Benetzungsauflage 10. Ausgehend von der zweiten Austrittsöffnung 22 erfolgt ein direkter Zugang zu dem Kanal 27, der wiederum an seinem Ausgang mit der Benetzungsauflage 11 in Kontakt ist. Wie bei dem in Fig. 2 dargestellten Beispiel kann auch in dieser Ausführungsform ein Solarmodul 6 mit an der Kante befindlichem Klebeband hineingeschoben bzw. in Längsachsenrichtung des Handgeräts 1 hindurchgeführt werden. Zweckmäßigerweise wird dabei das Handgerät 1 bewegt, während das Solarmodul 6 fix ist. Zur Arbeitserleichterung wird wiederum ein Griff verwendet (in Fig. 3 nicht dargestellt).

Zum Benetzen von U-förmig verklebtem Klebeband zur zeitweisen Inaktivierung des Klebebandes im Rahmen der Montage von Solarmodulen wird durch die Erfindung erstmals ein praktisches Handgerät als Arbeitsmittel zur Verfügung gestellt. Dies vereinfacht wesentlich den bisher mit Pinseln und Schwämmen durchgeführten Benetzungsprozess. Eine Positionierung der Benetzungsflüssigkeit sowie ein gleichmäßiger Auftrag der Benetzungsflüssigkeit lassen sich sehr einfach mit dem erfindungsgemäßen Handgerät erreichen. Eine Montage von Solarmodulen verläuft besser, schneller und damit kostengünstiger.

### Bezugszeichenliste:

| | |
|---|---|
| 1 | Handgerät |
| 2 | Klebeband |
| 3 | Vorratsbehälter |
| 4 | Benetzungsflüssigkeit |
| 5 | Grundkörper |
| 6 | Solarmodul |
| 7 | Seitenbereich |
| 8 | Seitenbereich |
| 9 | Bodenbereich |
| 10 | Benetzungsauflagen |
| 11 | Benetzungsauflagen |
| 12 | Flüssigkeitsleitsystem |
| 13 | Verzweigung |
| 14 | Zweig |
| 15 | Zweig |
| 16 | Ventilsystem |
| 17 | Kontaktplatte |
| 18 | Öffnung des Grundkörpers |
| 19 | Ventil |
| 20 | Oberfläche des Grundkörpers |
| 21 | Einfüllöffnung |
| 22 | Auslassöffnung |
| 23 | Auslassöffnung |
| 24 | Griff |
| 25 | Feder |
| 26 | Leitungsabschnitt |
| 27 | Leitungsabschnitt |
| 28 | Leitungsabschnitt |
| 29 | Leitungsabschnitt |

## Patentansprüche

1. Handgerät (1) zum Benetzen von U-förmig verklebtem Klebeband (2), das die folgenden Merkmale aufweist:
einen Vorratsbehälter (3) für Benetzungsflüssigkeit (4);
einen länglichen, im Querschnitt innenseitig U-förmigen Grundkörper (5) zur Aufnahme eines flachen, an einer Kante mit Klebeband (2) U-förmig umgebenen Objektes (6), wobei der Grundkörper (5) zwei einander gegenüberliegende Seitenbereiche (7, 8) und einen dazwischen befindlichen Bodenbereich (9) aufweist;
mindestens zwei saugfähige Benetzungsauflagen (10, 11), die innerhalb des Grundkörpers (6) einander gegenüberliegend angeordnet sind;
wobei zwischen dem Vorratsbehälter (3) und den Benetzungsauflagen (10, 11) ein Flüssigkeitsleitsystem (12) für die Benetzungsflüssigkeit (4) vorgesehen ist, das wenigstens teilweise innerhalb des Grundkörpers (5) verläuft.

2. Handgerät (1) gemäß Anspruch 1, wobei das Flüssigkeitsleitsystem (12) eine Verzweigung (13) derart aufweist, dass ein Zweig (14) hin zu der ersten Benetzungsauflage (10) und ein zweiter Zweig (15) hin zu der zweiten Benetzungsauflage (11) verläuft.

3. Handgerät (1) gemäß dem vorangehenden Anspruch, wobei die Verzweigung (13) im Bereich des Grundkörpers (5) vorgesehen ist.

4. Handgerät (1) gemäß einem der Ansprüche 2 bis 3, wobei die beiden Zweige (14, 15) konstruktiv identisch ausgebildet sind.

5. Handgerät (1) gemäß einem der Ansprüche 2 bis 3, wobei die beiden Zweige (14, 15) konstruktiv unterschiedlich ausgestaltet sind.

6. Handgerät (1) gemäß einem der vorangehenden Ansprüche, wobei das Flüssigkeitsleitsystem (12) durch die beiden Seitenbereiche (7, 8) des Grundkörpers (5) hindurch hin zu den beiden Benetzungsauflagen (10, 11) verläuft.

7. Handgerät (1) gemäß dem vorangehenden Anspruch, wobei das Flüssigkeitsleitsystem (12) ein Ventilsystem (16) zur Unterbrechung bzw. Freigabe der Flüssigkeitszufuhr aufweist.

8. Handgerät (1) gemäß dem vorangehenden Anspruch, wobei das Ventilsystem (16) im Bereich einer Verzweigung (13) des Flüssigkeitsleitsystems (12) angeordnet ist.

9. Handgerät (1) gemäß einem der Ansprüche 7 bis 8, wobei das Ventilsystem (16) mithilfe eines Bedienelementes betätigbar ist.

10. Handgerät (1) gemäß einem der Ansprüche 7 bis 8, wobei das Ventilsystem (16) eine federnd gelagerte Kontaktplatte (17) aufweist, die innerhalb der im Querschnitt U-förmigen Öffnung (18) des Grundkörpers (5) angeordnet ist und die durch Kontakt bzw. Druck so bewegt werden kann, dass sich das Ventilsystem (16) öffnet bzw. schließt.

11. Handgerät (1) gemäß dem vorangehenden Anspruch, wobei die Kontaktplatte (17) so angeordnet ist, dass sie orthogonal zu den beiden Benetzungsauflagen (10, 11) ist.

12. Handgerät (1) wenigstens gemäß einem der Ansprüche 7 bis 11, wobei das Ventilsystem (16) mehrere Ventile (19) und/oder das Flüssigkeitsleitsystem (12) mehrere Verzweigungen (13) aufweist.

13. Handgerät (1) gemäß einem der vorangehenden Ansprüche, wobei das Flüssigkeitsleitsystem (12) teilweise an bzw. auf der Oberfläche (20) des Grundkörpers (5) angeordnet ist.

14. Handgerät (1) gemäß einem der vorangehenden Ansprüche, wobei die Benetzungsauflagen (10, 11) Filz, Vlies und/oder Schaumstoff aufweisen.

15. Handgerät (1) gemäß einem der vorangehenden Ansprüche, wobei die Benetzungsauflagen (10, 11) umfänglich rechteckig und innerhalb des Grundkörpers (5) jeweils fest mit einem der Seitenbereiche (7, 8) verbunden sind.

16. Handgerät (1) gemäß einem der Ansprüche 1 bis 14, wobei die Benetzungsauflagen (10, 11) innerhalb des Grundkörpers (5) umfänglich rund und rotationsfähig jeweils vor einem der Seitenbereiche (10, 11) angeordnet sind.

17. Handgerät (1) gemäß dem vorangehenden Anspruch mit mehr als zwei Benetzungsauflagen.

18. Handgerät (1) gemäß einem der vorangehenden Ansprüche, wobei der Vorratsbehälter (3) im Wesentlichen flach ausgebildet ist.

19. Handgerät (1) gemäß einem der vorangehenden Ansprüche, wobei der Vorratsbehälter (3) an einem der Seitenbereiche (10, 11) angeordnet ist.

20. Handgerät (1) gemäß einem der vorangehenden Ansprüche, wobei der Vorratsbehälter (3) eine Einfüllöffnung (21) für Flüssigkeit (4) und/oder eine oder mehrere Auslassöffnungen (22, 23) zu dem Flüssigkeitsleitsystem (12) aufweist.

21. Handgerät (1) gemäß einem der vorangehenden Ansprüche mit einem Griff (24), der sich außenseitig entlang des Bodenbereiches (9) des Grundkörpers (5) erstreckt.

22. Verwendung eines Handgerätes (1) gemäß einem der vorangehenden Ansprüche 1 bis 21 zum Benetzen von Solarlaminat (6).
